# EUROPEAN PATENT APPLICATION

(11) **EP 3 650 939 A1**
(43) Date of publication of application: **13.05.2020**
(21) Application number: 18204882.7
(22) Date of filing: 07.11.2018
(51) Int. Cl.: G03F 7/20, G05B 13/02, H01L 21/66

(54) **PREDICTING A VALUE OF A SEMICONDUCTOR MANUFACTURING PROCESS PARAMETER**

(71) Applicant: ASML Netherlands B.V., 5500 AH Veldhoven (NL)
(72) Inventor: ROY, Sarathi, 5500 AH Veldhoven (NL)
(74) Representative: Peters, John Antoine

(57) **Abstract**

A value 608 of a high-order parameter associated with a semiconductor manufacturing process is obtained based on measurements 606 using a spatially dense sampling scheme. A recurrent neural network (NN) 604, such as a Long Short-Term Memory network, determines a predicted value 612 of the high-order parameter based on the measured value 608. The predicted value 612 obtained from measurements 606 at a first operation L1 of a process step in the manufacturing process is used to determine a control recipe 622 of a subsequent operation L2 of the process step. Meanwhile, a value 618 of a low-order parameter is obtained based on measurements (for example value 620 from measurements of lot at exposure step L2) using a spatially sparse sampling scheme. The value 620 of the low-order parameter is used to determine the control recipe 622 of the subsequent operation L2 of the process step.

## Description

### FIELD

The present invention relates to methods of predicting a value of parameter associated with a semiconductor manufacturing process, semiconductor manufacturing processes, lithographic apparatuses and associated computer program products.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as CD = ki×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k₁.

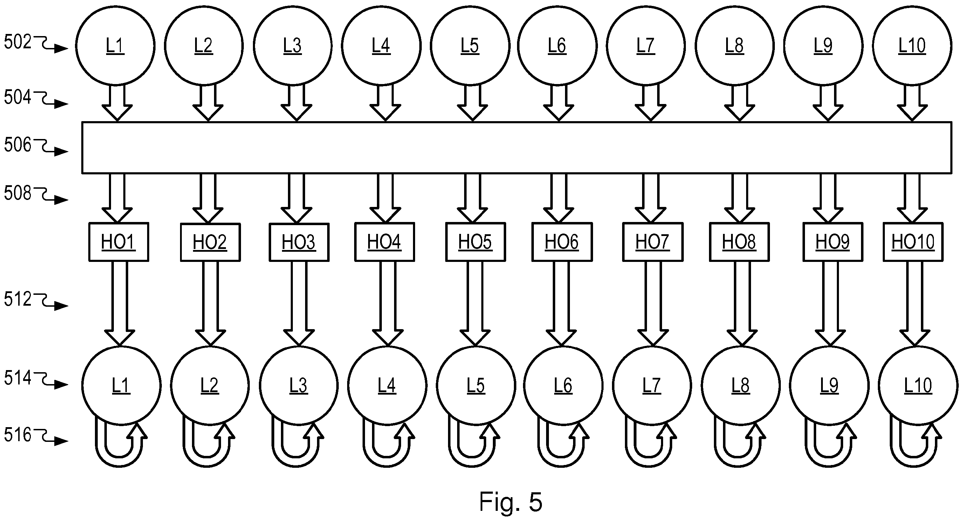

For alignment control, only small number of alignment marks can be measured (∼40) during exposure without impacting throughput. High-order alignment control requires denser alignment layout and impacts throughput. A solution to this problem, as shown in Figure 5 is to measure denser alignment marks in an offline tool (Takehisa Yahiro et. al., "Feed-forward alignment correction for advanced overlay process control using a standalone alignment station "Litho Booster"," Proc. SPIE 10585, Metrology, Inspection, and Process Control for Microlithography XXXII) and feed forward this high-order correction during exposure, where low-order corrections are still calculated during exposure.

For overlay control, dense overlay measurements can practically be performed only once in several lots (known as higher-order parameter update) to update the high-order correction. The high-order parameters used to determine the scanner control recipe do not change between higher-order parameter update measurements.

### SUMMARY

It is desirable to provide a method of predicting parameters associated with semiconductor manufacturing processes, that solves one or more of the above-discussed problems or limitations.

Embodiments of the invention are disclosed in the claims and in the detailed description.

In a first aspect of the invention there is provided a method for predicting a value of first parameter associated with a semiconductor manufacturing process, the method comprising:
- obtaining a first value of the first parameter based on measurements using a first sampling scheme; and
- using a recurrent neural network to determine a predicted value of the first parameter based on the first value.

Preferably, the method further comprises using the predicted value of the first parameter determined based on the first value obtained from measurements at a first operation of a process step in the semiconductor manufacturing process to determine a control recipe of a subsequent operation of the process step in the semiconductor manufacturing process.

In a second aspect of the invention there is provided a semiconductor manufacturing process comprising a method for predicting a value of a parameter associated with the semiconductor manufacturing process according to the method of any preceding claim.

In a third aspect of the invention there is provided a lithographic apparatus comprising:
- an illumination system configured to provide a projection beam of radiation;
- a support structure configured to support a patterning device, the patterning device configured to pattern the projection beam according to a desired pattern;
- a substrate table configured to hold a substrate;
- a projection system configured the project the patterned beam onto a target portion of the substrate; and
- a processing unit configured to:
   predict a value of a parameter associated with the semiconductor manufacturing process according to the method of the first aspect.

In a fourth aspect of the invention there is provided a computer program product comprising machine readable instructions for causing a general-purpose data processing apparatus to perform the steps of a method of the first aspect.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 depicts a schematic overview of overlay sampling and control of a semiconductor manufacturing process;
- Figure 5 depicts a schematic overview of known alignment sampling and control of a semiconductor manufacturing process;
- Figure 6 depicts a schematic overview of a method of sampling and control of a semiconductor manufacturing process in accordance with an embodiment of the present invention;
- Figure 7 is a graph of an overlay higher-order parameter update corresponding to the sampling and control scheme of Figure 4;
- Figure 8 is a graph of an overlay higher-order parameter update with no updates in accordance with an embodiment of the present invention;
- Figure 9 is a graph of an overlay higher-order parameter update with updates corresponding to the sampling and control scheme of Figure 6 in accordance with an embodiment of the present invention; and
- Figure 10 depicts wafer maps of measured overlay with no high-order overlay parameter correction, with overlay higher-order parameter update corresponding to Figure 7, and with overlay parameter prediction corresponding to Figures 8 and 9.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

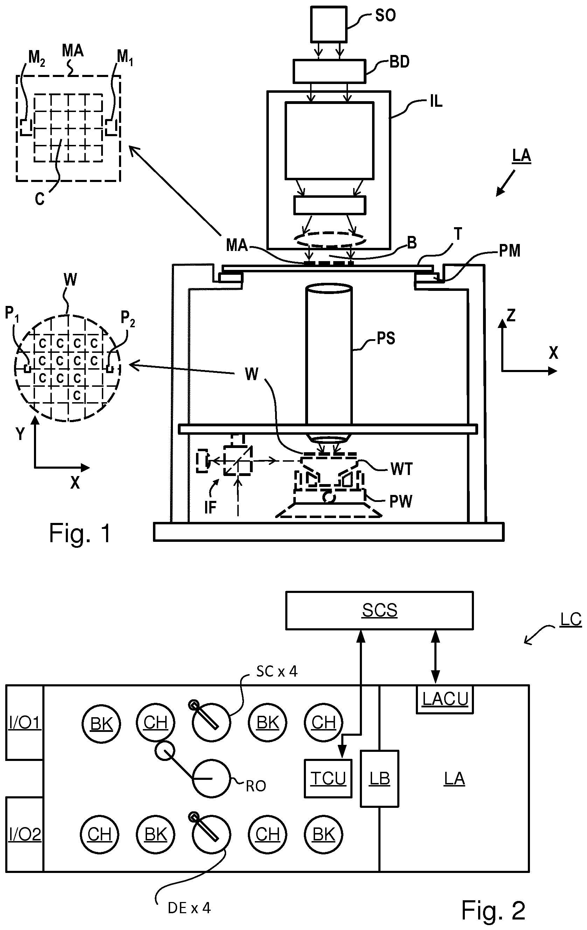

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

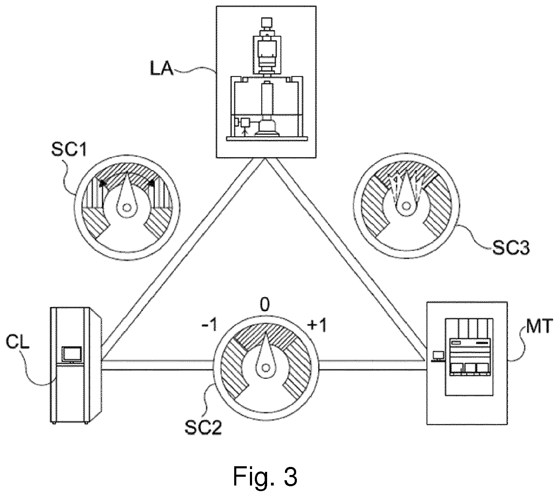

Typically, the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

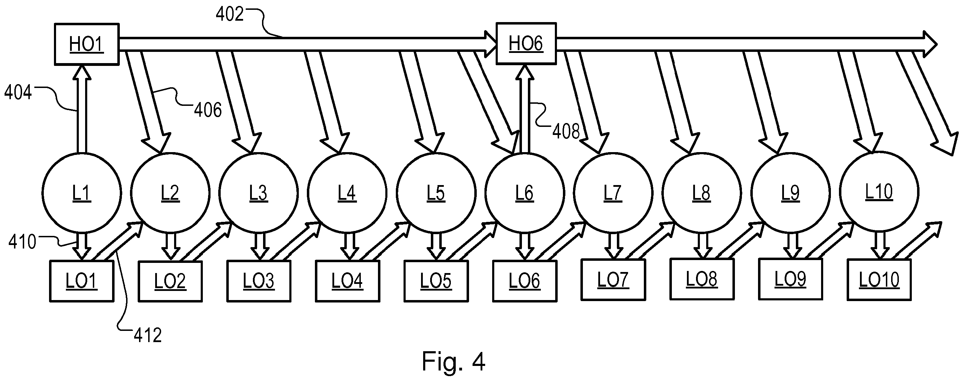

Figure 4 depicts a schematic overview of overlay sampling and control of a semiconductor manufacturing process. With reference to Figure 4, a sequence of ten operations L1 to L10 of an exposure process step on ten wafer lots (or batches, or wafers) are shown. A value of a high-order overlay parameter HO1 is obtained based on measurements 404 of the first lot L1 using a spatially dense sampling scheme. The high-order overlay parameter HO1 is used to determine control recipes 406 of subsequent exposures L2 to L6 of the next five lots. Then, an updated value of the high-order overlay parameter HO6 is obtained based on the earlier 402 high-order overlay parameter HO1 and based on measurements 408 of the sixth lot L6 using the spatially dense sampling scheme. In this example the higher-order parameter update repeats at the exposure of every fifth lot.

Meanwhile, for the exposure of every lot, low-order corrections are calculated per lot from sparse measurements. For example, at the exposure of lot L1 a low-order overlay parameter LO1 is obtained based on measurements 410 using a sparse sampling scheme, which is less spatially dense and more frequent than the spatially dense sampling scheme. The low-order parameter LO1 is used to determine the control recipe 412 of the subsequent operation L2 of the exposure step, and so on.

Thus, the low-order corrections are calculated per lot from sparse measurements, and high-order corrections are obtained from dense measurements once in several lots.

Figure 5 depicts a schematic overview of alignment sampling and control of a semiconductor manufacturing process. With reference to Figure 5, wafer lots L1 to L10 have an off-line alignment mark measurement step 502. The measurements 504 are performed by an off-line measurement tool, 506, which is optimized for off-line measurements with a high spatial sampling density. The measured high-order alignment parameter values 508 are stored HO1 to HO10 for each wafer lot L1 to L10. Then each high-order alignment parameter value is used to to determine a control recipe 512 of the operation of an exposure step 514 on the corresponding wafer lot L1 to L10.

Meanwhile, for the exposure of every lot, low-order corrections are calculated per lot from sparse measurements. For example, at the exposure 514 of lot L1, a low-order alignment parameter 516 is obtained based on measurements using a sparse sampling scheme, which is less spatially dense than the spatially dense sampling scheme. It has the same frequency (per lot) as the offline dense measurements 504 of the high-order alignment parameters. The low-order parameter 516 is used to determine the control recipe of the operation L1 of the same exposure step.

Embodiments use a strategy for updating both overlay and alignment measurements in-between dense measurements using a Long Short-Term Memory (LSTM) prediction algorithm. This improves the performance of alignment and overlay control with minimum impact on throughput. A completely independent LSTM network prediction (no dense measurement required after training) is also possible, however it may diverge after some time if the learning becomes inadequate.

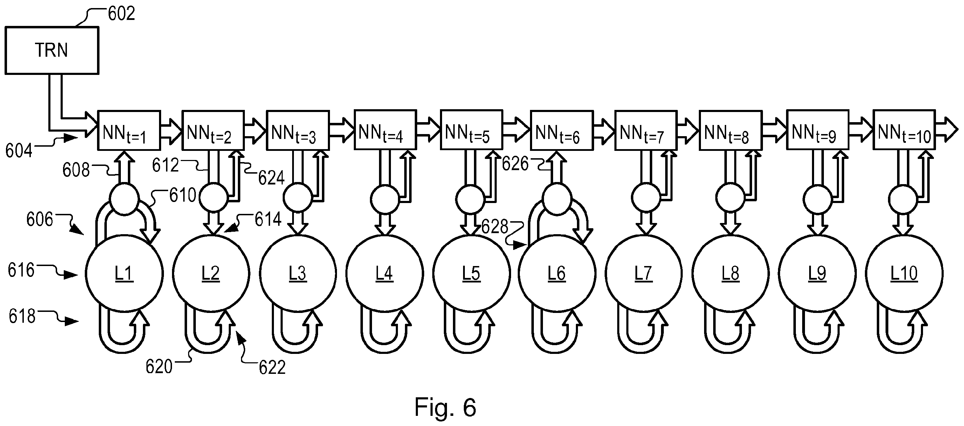

Figure 6 depicts a schematic overview of a method of sampling and control of a semiconductor manufacturing process in accordance with an embodiment of the present invention.

With reference to Figure 6, updating of high-order parameters is achieved with prediction in in-between lots/wafers using a LSTM neural network. This provides improved high-order correction for both alignment and overlay. The low-order corrections are measured per wafer, while the high-order corrections are predicted with LSTM in in-between lots/wafers. The neural network is configured with an initial training (TRN) step 602.

Figure 6 depicts a method for predicting a value of a high-order parameter associated with a semiconductor manufacturing process. In this example, the semiconductor manufacturing processes a lithographic exposure process. The parameter is the third-order scanner exposure magnification parameter in the y-direction, D3y. The method involves obtaining a value 608 of the high-order parameter based on measurements 606 using a spatially dense sampling scheme. A recurrent neural network (NN) 604 is used to determine a predicted value 612 of the high-order parameter based on the measured value 608. The measured value 608 of the high-order parameter can be used directly 610 to determine the control recipe for processing of the measured lot.

The predicted value 612 of the high-order parameter is determined based on the value 608 of the high-order parameter obtained from measurements 606 at a first operation L1 of a process step in the semiconductor manufacturing process to determine a control recipe 614 of a subsequent operation L2 of the process step in the semiconductor manufacturing process. The predicted value is fed back 624 into the recurrent neural network (NNₜ₌₂). For exposure of lots L3 to L5, the recurrent neural network (NN_{t=2..5}) updates itself to produce predicted values which are used to determine control recipes for successive lots. A subsequent value 626 of the high-order parameter is obtained based on measurements 628 using the dense sampling scheme. The recurrent neural network is updated (NNₜ₌₆) using the subsequent value 626.

Meanwhile, a value 618 of a low-order parameter is obtained based on measurements (for example value 620 from measurements of lot at exposure step L2) using a spatially sparse sampling scheme. The sparse sampling scheme is less spatially dense and more frequent than the high-order sampling scheme used for measurements 606, 628. The value 620 of the low-order parameter is used to determine the control recipe 622 of the subsequent operation L2 of the exposure process step.

The value 620 of the low-order parameter may be obtained based on measurements performed on the same substrate supported on the same substrate table at which the subsequent operation L2 of the process step is performed. The control recipe 622 is determined using the value 620 of the low-order parameter.

In this example, the semiconductor manufacturing process is a batch-wise process of patterning substrates. The sampling scheme for obtaining high-order parameters has a measurement frequency of per 5 (as shown in Figure 6) to 10 batches. The second sampling scheme has a measurement frequency of one per batch.

In this example, the semiconductor manufacturing process is a process of patterning substrates using exposure fields. The sampling scheme for obtaining high-order parameters has a spatial density of 200 to 300 measurement points per field and the sampling scheme for obtaining low-order parameters has a spatial density of 2 to 3 measurement points per field.

The method of predicting a value of a parameter associated with the semiconductor manufacturing process, as described with reference to Figure 6 may be implemented within a semiconductor manufacturing process. The method may be implemented in a lithographic apparatus with processing unit, such a LACU in Figure 2. It may be implemented in a processor in the supervisory control system SCS of Figure 2 or computer system CL of Figure 3.

The invention may also be embodied as a computer program product comprising machine readable instructions for causing a general-purpose data processing apparatus to perform the steps of a method as described with reference to Figure 6.

It is an advantage of the method of Figure 6 that for overlay no additional measurement is required, compared to the method of Figure 4. For alignment, only few wafers per lot are required to have spatially dense measurements, while all wafers receive different control recipes determined based on different high-order parameters. The in-between lots (for overlay) or wafers (for alignment) receive updated control recipes determined with high-order parameters predicted by the LSTM. Wafer table (chuck) matching is not required because the low-order measurements and corresponding control recipe update are performed on the same wafer table, for overlay and alignment parameters.

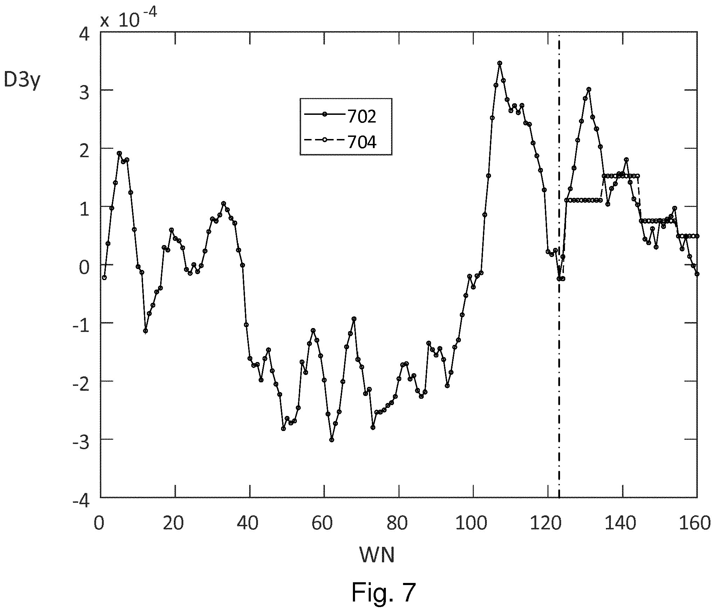

Figure 7 is a graph of an overlay higher-order parameter update corresponding to the sampling and control scheme of Figure 4. In Figures 7 to 9, the horizontal axis is wafer number WN. The vertical axis is the third-order scanner exposure magnification parameter in the y-direction D3y. In Figures 7 to 9, the solid line graph 702 is the original value of the high-order parameter from dense measurement sampling.

With reference to Figure 7, the dashed line graph 704, to the right of the vertical dot-dash line is the higher-order parameter update with the parameter being updated every 10 points (note that Figure 4 shows this update every 5 points).

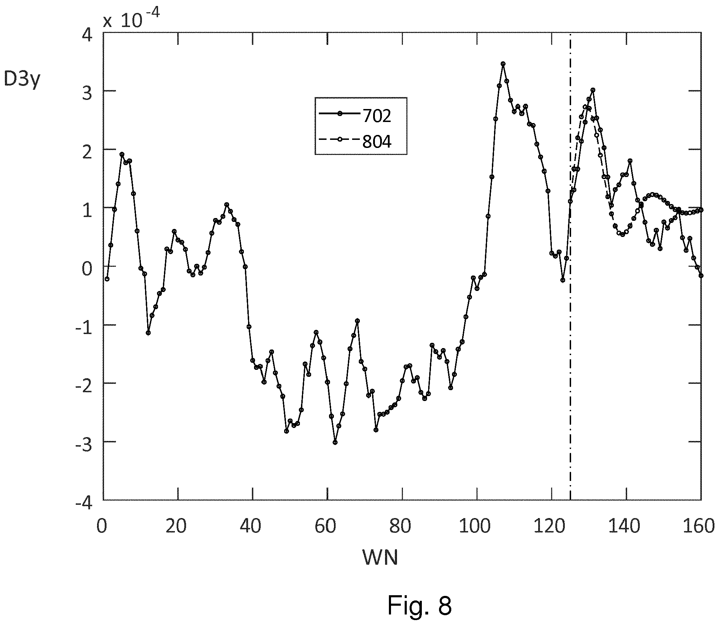

Figure 8 is a graph of an overlay higher-order parameter update with no updates in accordance with an embodiment of the present invention.

With reference to Figure 8, the dashed line graph 804, to the right of the vertical dot-dash line is the predicted parameter value with no updates. This would correspond to Figure 6, but without an update at L6 or subsequently. Thus it uses a free LSTM, with no updates after training.

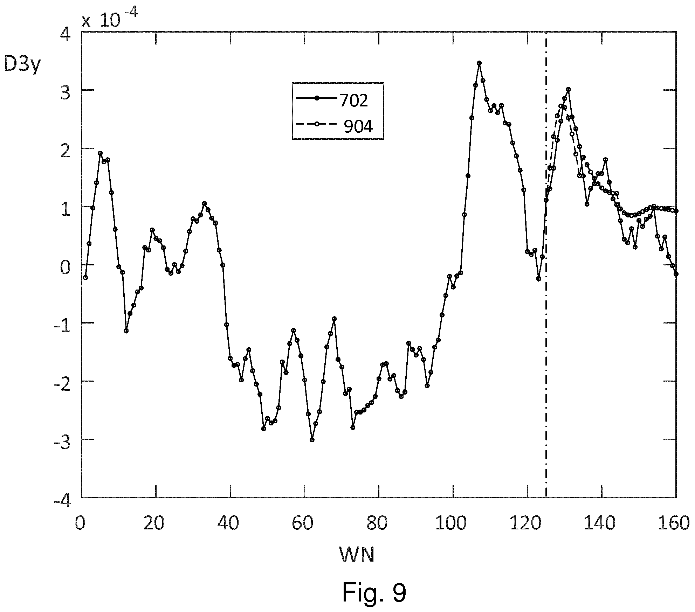

Figure 9 is a graph of an overlay higher-order parameter update with updates corresponding to the sampling and control scheme of Figure 6 in accordance with an embodiment of the present invention.

With reference to Figure 9, the dashed line graph 904, to the right of the vertical dot-dash line is the predicted parameter value with updates every 10 points (note that Figure 6 shows this update every 5 points). The LSTM network is trained with 78% of the data, to the left of the vertical dot-dash line. The LSTM network is validated on the rest (22% - 35 wafers, dashed line 904). The root mean square error (RMSE) between original and predicted D3y is best for Figure 9 (RMSE = 2.12e-05), while Figure 8 (RMSE = 2.83e-05) and Figure 7 (RMSE = 2.82e-05) are comparable.

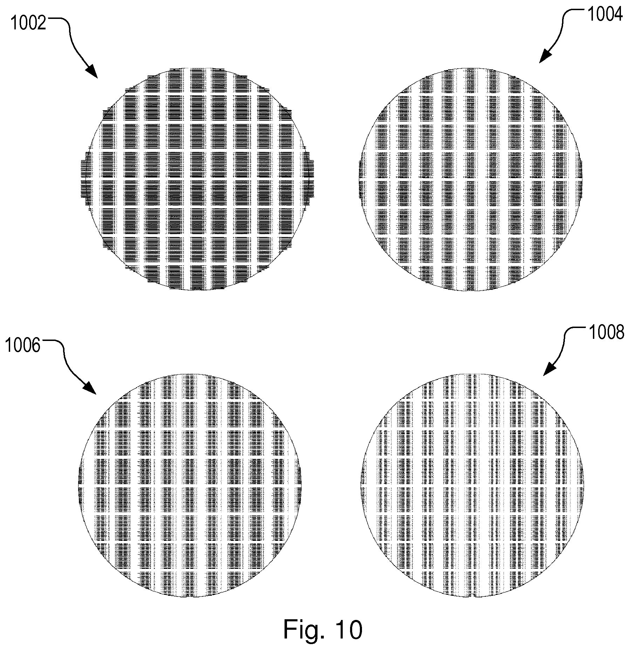

Figure 10 depicts wafer maps of measured overlay with no high-order overlay parameter correction, with overlay higher-order parameter update corresponding to Figure 7, and with overlay parameter prediction corresponding to Figures 8 and 9.

In the wafer plots the real corrections are applied on dense (13*19 points per field) layout and the correction capability for each case is compared. The plots show mean plus 3 sigma overlay. A darker pattern represents worse overlay performance. A baseline wafer map 1002 is shown with no high-order correction. The wafer map 1004 results from overlay higher-order parameter update corresponding to the plot of Figure 7, for conventional overlay. The wafer map 1006 results from overlay higher-order parameter update corresponding to the plot of Figure 8, for a free LSTM with no updates. The wafer map 1008 results from overlay higher-order parameter update corresponding to the plot of Figure 9, which is for LSTM prediction with updates. The latter has the best overlay correction performance, shown by the lighter pattern.

Embodiments provide a way to include high-order parameters into alignment correction without measuring each wafer. Embodiments also improve the methodology for updating overlay measurements.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of an inspection or metrology apparatus, embodiments of the invention may be used in other apparatus. Embodiments of the invention may form part of a mask inspection apparatus, a lithographic apparatus, or any apparatus that measures or processes an object such as a wafer (or other substrate) or mask (or other patterning device). It is also to be noted that the term metrology apparatus or metrology system encompasses or may be substituted with the term inspection apparatus or inspection system. A metrology or inspection apparatus as disclosed herein may be used to detect defects on or within a substrate and/or defects of structures on a substrate. In such an embodiment, a characteristic of the structure on the substrate may relate to defects in the structure, the absence of a specific part of the structure, or the presence of an unwanted structure on the substrate, for example.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of physical systems such as structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of a physical structure may relate to defects in the structure, the absence of a specific part of the structure, or the presence of an unwanted structure on the substrate or on the wafer.

Although specific reference may have been made above to the use of embodiments of the invention in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. With respect to the multi-sensitivity target embodiment, the different product features may comprise many regions with varying sensitivities (varying pitch etc.). Further, pitch p of the metrology targets is close to the resolution limit of the optical system of the scatterometer, but may be much larger than the dimension of typical product features made by lithographic process in the target portions C. In practice the lines and/or spaces of the overlay gratings within the target structures may be made to include smaller structures similar in dimension to the product features.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

## Claims

1. A method for predicting a value of first parameter associated with a semiconductor manufacturing process, the method comprising:
- obtaining a first value of the first parameter based on measurements using a first sampling scheme; and
- using a recurrent neural network to determine a predicted value of the first parameter based on the first value.

2. The method of claim 1, further comprising using the predicted value of the first parameter determined based on the first value obtained from measurements at a first operation of a process step in the semiconductor manufacturing process to determine a control recipe of a subsequent operation of the process step in the semiconductor manufacturing process.

3. The method of claim 2, further comprising:
- obtaining a second value of a second parameter based on measurements using a second sampling scheme being less spatially dense and more frequent than the first sampling scheme; and
- using the second value of the second parameter to determine the control recipe of the subsequent operation of the process step.

4. The method of claim 3, wherein the second value is obtained based on measurements at the subsequent operation of the process step.

5. The method of claim 4, wherein the second value is obtained based on measurements performed on the same substrate supported on the same substrate table at which the subsequent operation of the process step is performed with the control recipe determined using the second value.

6. The method of any of claims 3 to 5, wherein the semiconductor manufacturing process is a batch-wise process of patterning substrates, and wherein the first sampling scheme has a measurement frequency of per 5 to 10 batches and the second sampling scheme has a measurement frequency of one per batch.

7. The method of any of claims 3 to 6, wherein the semiconductor manufacturing process is a process of patterning substrates using exposure fields, and wherein the first sampling scheme has a spatial density of 200 to 300 measurement points per field and the second sampling scheme has a spatial density of 2 to 3 measurement points per field.

8. The method of any preceding claim, further comprising obtaining a subsequent value of the first parameter based on measurements using the first sampling scheme and updating the recurrent neural network using the subsequent value.

9. The method of any preceding claim, wherein the parameter comprises an exposure magnification parameter and the process step comprises lithographic exposure.

10. The method of any preceding claim, wherein the recurrent neural network comprises a Long Short-Term Memory network.

11. A semiconductor manufacturing process comprising a method for predicting a value of a parameter associated with the semiconductor manufacturing process according to the method of any preceding claim.

12. A lithographic apparatus comprising:
- an illumination system configured to provide a projection beam of radiation;
- a support structure configured to support a patterning device, the patterning device configured to pattern the projection beam according to a desired pattern;
- a substrate table configured to hold a substrate;
- a projection system configured the project the patterned beam onto a target portion of the substrate; and
- a processing unit configured to:
predict a value of a parameter associated with the semiconductor manufacturing process according to the method of any of claims 1 to 10.

13. A computer program product comprising machine readable instructions for causing a general-purpose data processing apparatus to perform the steps of a method as claimed in any of claims 1 to 10.
